# EUROPEAN PATENT SPECIFICATION

(11) **EP 0 392 714 B1**
(45) Date of publication and mention of the grant of the patent: **18.06.1997**
(21) Application number: 90303464.3
(22) Date of filing: 30.03.1990
(51) Int. Cl.: H01L 33/00, H01S 3/025

(54) **A semiconductor laser device**
Halbleiterlaservorrichtung
Dispositif laser à semi-conducteur

(30) Priority: 12.04.1989 JP 93580/89
(43) Date of publication of application: 17.10.1990
(73) Proprietor: MITSUBISHI DENKI KABUSHIKI KAISHA, Tokyo 100 (JP)
(72) Inventor: Kubota, Masayuki, c/o Mitsubishi Denki K.K., Itami-Shi, Hyogo-ken (JP)
(74) Representative: Beresford, Keith Denis Lewis

(56) References cited:
- EP-A- 0 187 198
- EP-A- 0 267 036
- US-A- 4 847 848
- PROCEEDINGS OF THE SPIE LASER DIODE TECHNOLOGY AND APPLICATIONS CONFERENCE, Los Angeles, California, 18th - 20th January 1980, vol. 1043, pages 17-24; T. YAMAGUCHI et al.: "Monolithic four-beam semiconductor laser array with built-in monitoring photodiodes"
- PATENT ABSTRACTS OF JAPAN, vol. 10, no. 39 (E-381)[2096], 15th February 1986; & JP-A-60 195 985 (ANRITSU DENKI K.K.) 04-10-1985
- IBM TECHNICAL DISCLOSURE BULLETIN, vol. 27, no. 7B, December 1984, pages 4344-4345, New York, US; P.M. MOONEY: "Photodiode array for monitoring individual lasers in a laser array"
- IEEE JOURNAL OF QUANTUM ELECTRONICS, vol. QE-16, no. 5, May 1980, pages 502-504, New York, US; D.R. SCIFRES et al.: "Intergrated output power detection for AlGaAs laser array"

## Description

The present invention relates to a semiconductor laser device, particularly one which can be used as a light source in, for example, an optical disk apparatus or a laser beam printer, and more particularly to one which is capable of independently monitoring the laser light bundles emitted from a laser array.

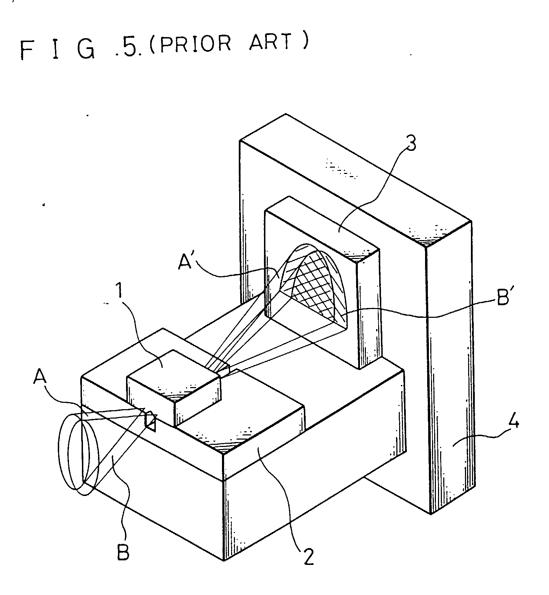

Figure 5 shows a construction of a prior art semiconductor laser device using a two beam semiconductor laser diode array. In figure 5, reference numeral 1 designates the two beam semiconductor laser diode array (hereinafter referred to as "two beam LD array") having a pair of light emission portions. Reference numeral 2 designates a submount for fixing the two beam array LD element 1. Reference numeral 3 designates a photodetector for detecting the light bundles which are emitted from the rear facet of the two beam LD array 1. Reference numeral 4 designates a stem for fixing the submount 2 and the photodetector 3. Reference characters A and B designate light bundles which are emitted from the front facet of the two beam LD array 1. Reference characters A' and B' designate light bundles which are emitted from the rear facet of the two beam LD array 1. These light bundles A' and B' are emitted from the same cavity as that for the light bundles A and B, respectively.

The device will operate as follows.

When a current is applied to the two beam LD array 1, light bundles A and B are emitted from the front facet of the array and the light bundles A' and B' are emitted from the rear facet thereof. Since the light bundles A and A', and the light bundles B and B' are emitted from the same cavity, respectively, the light intensities of the light bundles A and A' and those of the light bundles B and B' are in proportional relationship. Accordingly, the light intensities of the light bundles A and B can be monitored by detecting the light intensities of the light bundles A' and B', respectively, by the photodetector 3, which are emitted from the rear facet of the two beam LD array 1.

Since there may be cases where the two beam LD array should be used with the two light emission portions emitting independently in practice, the two beam LD array 1 and the submount 2 are provided with a separation groove for electrically separating the two light emission portions. Further, the interval between the two light emission portions is set at about 100 to 200 µm. The prior art semiconductor laser device is constructed in such a manner, and the two light bundles A' and B' emitted from the rear facet of the two beam LD array 1 have divergence angles of about 10° to 15° in the direction of a straight line connecting the two light emission points, whereby the light bundles A' and B' overlap on the photodetector 3. Accordingly, although the two light emission portions are constructed capable of conducting independent light emission, it is impossible to independently monitor the light intensities of the light bundles A' and B' by the photodetector 3. Furthermore, although the photodetector is stereoscopically constructed using a stem so as to enable to sufficiently receive laser light diverging in the longitudinal direction in order to enhance the detection efficiency of the photodetector, the above-described construction requires that the bonding of the laser array and of the photodetector should be conducted by rotating the device through 90°, thereby complicating the fabrication process.

The problem of preventing bundle overlap and cross-talk has been addressed in the following published article "Monolithic Four-Beam Semiconductor Laser Array with Built-in Monitoring Photodiodes" by Yamaguchi, T. et al, SPIE Vol. 1043, Laser Diode Technology and Applications, 18-20 January 1989, pages 17-24. This discloses a solution in which light from a laser array is channelled to photodetectors using grooves coated with a highly reflective material in the surface of a Si substrate, the photodetectors being mounted in a plane at 90° to the plane of the substrate. Since separate light guide grooves are provided, there is no overlap permitted between the divergent light bundles and respective light bundles are directed onto respective photodetectors.

In common with the present invention the above-mentioned article provides a semiconductor laser device comprising:
a substrate;
a semiconductor laser array, disposed at a main surface of said substrate, having front and rear facets, emitting in use a plurality of first laser light bundles from the front facet, and emitting in use from the rear facet a same plurality of second laser light bundles, of light intensities proportional to the light intensities of said first laser light bundles, respectively;
a same plurality of photodetectors arranged to receive and detect the respective second laser light bundles to provide an independent monitoring of the light bundle intensities of the respective first laser light bundles; and
lightguide means, also disposed at said main surface of said substrate, arranged between said semiconductor laser array and said plurality of photodetectors, to guide each respective second laser light bundle to each respective photodetector.

Since, however, the photodetectors are mounted in a plane at 90° to the plane of the substrate, fly-wire bonding is necessary and processing is thus complicated as already mentioned above in the context of the construction shown in figure 5, since 90° rotation is required.

The present invention not only provides a solution to the problem of facilitation of independent monitoring and avoidance of cross-talk, but it also provides a solution to the problem of simplifying structure and processing, thus avoiding fly-wire bonding to perpendicular surfaces.

A semiconductor laser device in accordance with the present invention is characterised in that:
said lightguide means is comprised of a lightguide layer, disposed on said main surface of said substrate, which layer has defined therein a lens arranged to intercept and focus each of said second laser light bundles to a separate focus in the plane of said light guide layer; and
said plurality of photodetectors is disposed at said main surface of said substrate in a planar configuration relative to both said semiconductor laser array and said lightguide layer, adjacent to output points of said second laser light bundles, at positions where the guided laser light bundles are focused at the output side of the lightguide layer and is coupled to said lightguide layer to receive and detect said plurality of second laser light bundles focused by said lens.

In this device, although the light bundles emitted from the rear facet overlap within the lightguide layer, they are each brought to a separate focus and thus are separated prior to detection by the respective photodetectors. Independent monitoring is thus achieved and cross-talk is avoided. Also, since the laser array, lightguide layer and the photodetectors are arranged in a planar configuration, the provision of wiring and/or wire-bonding is simplified since 90° rotation is not required.

It is known to couple a single beam laser to a sensor using a lightguide layer. European Patent Application EP-A-0267036 discloses such a coupling arrangement in which a portion of a forward directed laser bundle is diverted to a sensor at a side of the lightguide layer using a collimating dielectric lens and a beam splitter integrated with the lightguide layer. This has application to an optical head in which the remainder portion of the forward directed laser bundle is focused out of the plane of the lightguide layer by a focus grating coupler.

The substrate may be an insulating substrate, in which case the semiconductor laser array and the photodetectors are disposed on said main surface of the substrate adjacent to the light input side and the light output side of the lightguide layer respectively.

Alternatively, the substrate may be of Si semiconductor material, in which case the photodetectors may be integrated with the substrate and the lightguide layer is arranged to overlap the photodetectors integrated with the substrate. Coupling between the photodetectors and the overlapping lightguide layer can be improved by providing a surface grating in the lightguide layer at the region of overlap with the photodetectors.

It is known to use a Si semiconductor substrate and to couple a laser array to photodiode detectors integrated with the substrate. In the following published article "Photodiode array for monitoring individual lasers in a laser array", Mooney, P.M., IBM Technical Disclosure Bulletin, Vol.27, No. 7B, December 1984, pages 4344-4345 there is disclosed a semiconductor laser device in which an array of GaAs lasers is mounted on a silicon substrate in close proximity to photodiodes integrated with the substrate. As they are in close proximity bundle overlap is significantly reduced, if not avoided altogether.

In the accompanying drawings:
Figure 1 is a diagram showing a construction of a semiconductor laser device utilising a two beam semiconductor laser array according to a first embodiment of the present invention;
Figure 2 is a diagram for explaining the manner of focusing respective emitted laser light bundles in the embodiment of figure 1;
Figure 3(a) is a diagram showing a construction of a semiconductor laser device according to a second embodiment of the present invention;
Figure 3(b) is a diagram showing a cross-section of the device of figure 3(a);
Figure 4 is a diagram showing a cross-section of a semiconductor laser device according to a third embodiment of the present invention; and
Figure 5 is a diagram showing a prior art two beam semiconductor laser array device.

Embodiments of the present invention now will be described in detail with reference to the drawings.

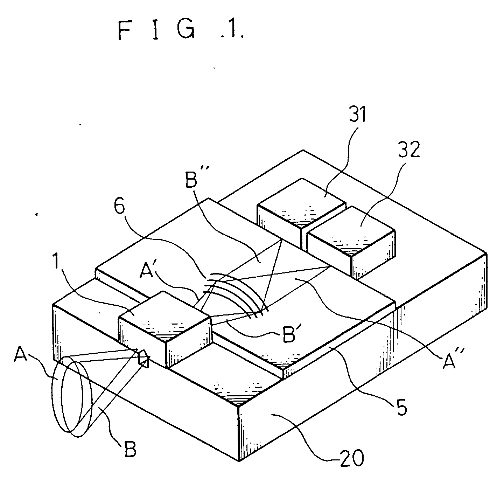

Figure 1 shows a construction of a semiconductor laser device according to a first embodiment of the present invention. In figure 1, reference numeral 20 designates an insulating substrate. A two beam LD array 1 is fixed on the substrate 20. A lightguide layer 5 is produced on a surface of the substrate 20 on which the two beam LD array 1 is fixed. A lens 6 is produced in the lightguide layer 5. Photodetectors 31 and 32 are disposed on the surface of the substrate 20, which receive and detect the light bundles A' and B' which are emitted from the rear facet of the two beam LD array 1 and guided in the lightguide layer 5. Reference characters A and B designate light bundles emitted from the front facet of the two beam LD array 1.

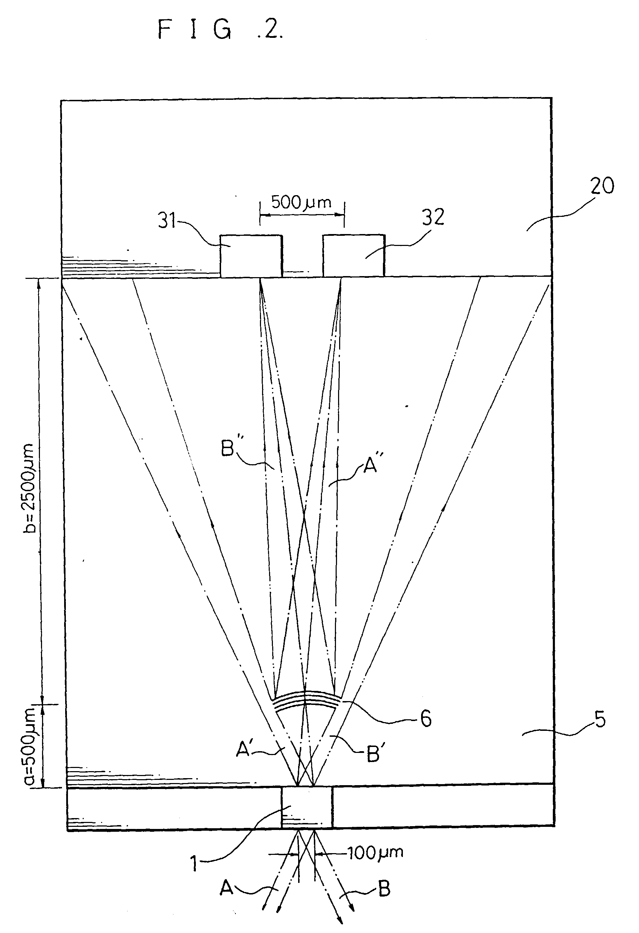

Figure 2 shows light paths associated with the manner of light focusing of the emitted laser light bundles of the embodiment of figure 1.

The two beam LD array 1 is fixed onto the substrate 20 as shown in figure 1, and a lightguide layer 5 comprising dielectric material such as LiNb0₃ in which Ti is diffused is produced adjacent to the rear facet of the two beam LD array 1 on the substrate 20 by a method such as sputtering. In this lightguide layer 5, a lens 6 which converts the divergent light guided in the layer 5 to a focused light by wave front conversion is produced by a method such as proton exchange. The photodetectors 31 and 32 are fixed at positions where the guided light bundles A" and B" are focused at the output side of the lightguide layer 5.

The device will operate as follows.

By applying a current to the two beam LD array 1, laser light bundles A and B are emitted from the front facet of the LD array 1 and laser light bundles A' and B' are emitted from the rear facet corresponding to the laser light bundles A and B from the front facet, respectively. In the laser device, the photodetectors receive the rear facet emission light bundles and detect the light output intensities. The magnitude of the current applied to the laser element is controlled on the basis of the light output intensities, thereby to control the light output from the front facet. In this embodiment, the laser light bundles A' and B' emitted from the rear facet of the LD element 1 are guided by the lightguide layer 5. In this lightguide layer 5, the laser light bundles A' and B' are converted into focused light bundles A" and B" from the diverging light bundles by the lens 6, and these focused light bundles A" and B" are separately input to the photodetectors 32 and 31 which are provided at the rear end of the lightguide layer 5, respectively.

Figure 2 shows the manner of lightguiding the emitted laser light bundles in the lightguide layer 5 together with examples of actual sizes of the device.

In this embodiment, a lightguide layer 5 having a focusing function is provided, and the rear facet emission laser lights of the LD array 1 are guided to be input separately into the photodetectors 32 and 31. Therefore, the rear facet emission laser light bundles do not overlap on a photodetector as in the prior art device, and the light intensities of the light bundles A" and B" can be detected independently by the respective photodetectors 32 and 31, and the light intensities of each of the light bundles A and B emitted from the front facet of the two beam LD array 1 can be monitored.

In the construction of the prior art semiconductor laser device, since the photodetectors are stereoscopically fixed to the stem, so as to enable to efficiently detect the monitor lights, wire bondings have to be conducted stereoscopically to the electrodes of the laser array and photodetectors. In this embodiment, however, since all of the wire bondings can be conducted in one plane, the production process can be simplified to a great extent.

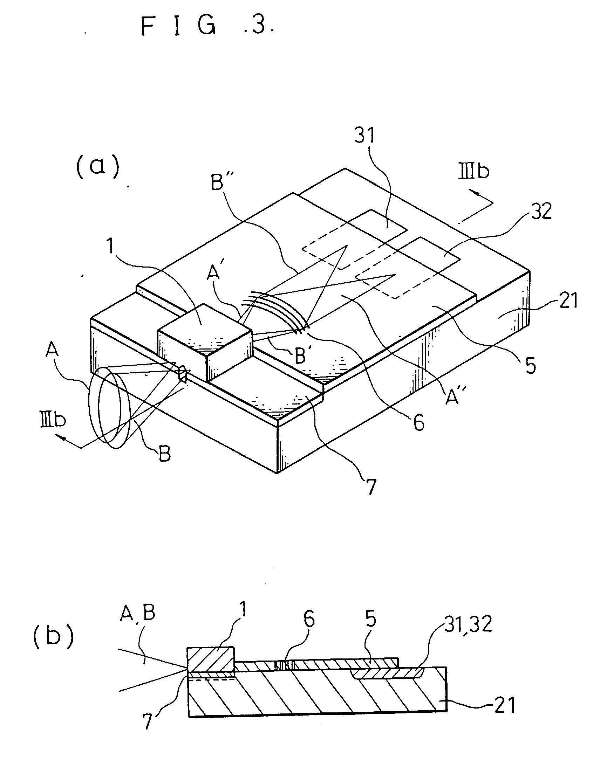

Figure 3 shows a semiconductor laser device according to a second embodiment of the present invention. Figure 3(a) shows a perspective view, and figure 3(b) shows a cross-sectional view in the IIIb - IIIb line in figure 3(a).

In these figures, the same reference numerals as those in figure 1 designate the same or corresponding features, reference numeral 21 designates a silicon substrate, and reference numeral 7 designates an insulating layer.

In this second embodiment, an n type silicon substrate is used for the substrate 21, and p type impurities are introduced to the regions where photodetectors are to be produced by such as diffusion, and those regions are used as photodetectors 31 and 32. Thereafter, the lightguide layer 5 and the lens 6 are produced by a similar method as in the first embodiment. On the other hand, in order to operate independently the respective light emission portions of the two beam LD array 1, an insulating layer 7 is provided at a region where the two beam LD array 1 is to be fixed so as to electrically separate the element 1 from the silicon substrate. Silicon oxide or the like may be used for this insulating layer 7. Herein, this layer 7 may be produced by p type semiconductor layer and insulated by a p-n reverse junction determined by the directions of the laser driving current and the bias current. Thereafter, a two beam array LD element 1 is fixed onto the insulating layer 7.

The device will operate as follows.

In the semiconductor laser device constructed in such a manner, the light bundles A' and B' introduced into the lightguide layer 5 are separated and focused by the lens 6 to light bundles A" and B", and the light bundles A" and B" propagate to the photodetectors 32 and 31. The light intensities of the light bundles A" and B" can be detected by the photodetectors 32 and 31, respectively, and similarly as in the first embodiment, the light output intensities of the light bundles A and B emitted from the front facet of the two beam LD array 1 can be monitored. Furthermore, in this embodiment, since the photodetectors 31 and 32 are fabricated on a substrate, the fabrication process is simplified.

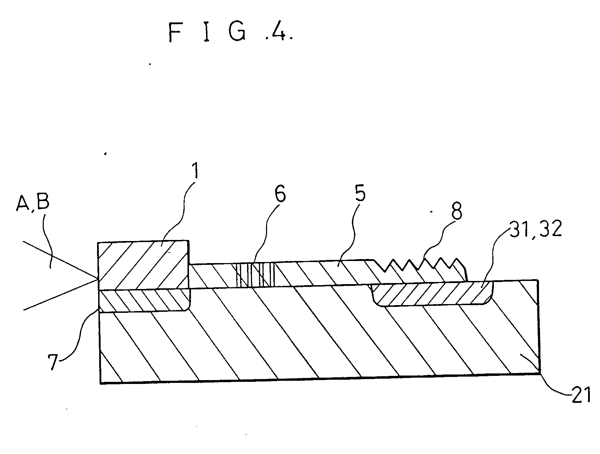

Figure 4 shows a cross-sectional view of a semiconductor laser device according to a third embodiment of the present invention. In figure 4, the same reference numerals as those of figure 3(b) designate the same or corresponding portions, and reference numeral 8 designates a a grating produced on the lightguide layer 5 over the photodetectors 31 and 32.

In this third embodiment, the light output intensities of the light bundles A and B emitted from the front facet of the two beam LD array 1 can be monitored in the same operation as that of the second embodiment. In the above-described second embodiment, the coupling efficiency between the light bundles A" and B" and the photodetectors 32 and 31 is low. In this third embodiment, by providing a grating 8 as shown in figure 4, the light bundles A" and B" are diffracted towards the light photodetectors 32 and 31. Therefore, the light coupling efficiency between the photodetectors 32 and 31 and the light bundles A" and B" can be enhanced, thereby obtaining improved characteristics.

While in the above-illustrated embodiment a semiconductor laser device using a two beam LD array is described, the laser device may have three or more light emission points. Further, if the light emission points can be produced sufficiently close to each other, the laser device can be produced in a multi-point emission type by using a plurality of independent laser elements, instead of using a monolithic element.

## Claims

1. A semiconductor laser device comprising:
a substrate (20,21);
a semiconductor laser array (1), disposed at a main surface of said substrate (20,21), having front and rear facets, emitting in use a plurality of first laser light bundles (A,B) from the front facet, and emitting in use from the rear facet a same plurality of second laser light bundles (A',B') of light intensities proportional to the light intensities of said first laser light bundles (A,B), respectively;
a same plurality of photodetectors (32,31) arranged to receive and detect the respective second laser light bundles (A',B') to provide an independent monitoring of the light bundle intensities of the respective first laser light bundles (A,B); and
lightguide means (5,6), also disposed at said main surface of said substrate (20,21), arranged between said semiconductor laser array (1) and said plurality of photodetectors (32,31), to guide each respective second laser light bundle (A',B') to each respective photodetector (32,31);
which semiconductor laser device is characterised in that:
said lightguide means (5,6) is comprised of a lightguide layer (5), disposed on said main surface of said substrate (20,21), which layer (5) has defined therein a lens (6) arranged to intercept and focus each of said second laser light bundles (A',B') to a separate focus in the plane of said light guide layer (5); and
said plurality of photodetectors (32,31) is disposed at said main surface of said substrate (20,21) in a planar configuration relative to both said semiconductor laser array (1) and said lightguide layer (5), adjacent to output points of said second laser light bundles (A',B'), at positions where the guided laser light bundles (A",B") are focused at the output side of the lightguide layer (5) and is coupled to said lightguide layer (5) to receive and detect said plurality of second laser light bundles (A",B") focused by said lens (6).

2. A semiconductor laser device as claimed in claim 1 wherein:
said substrate (20,21) is an insulating substrate (20); and
said semiconductor laser array (1) and said plurality of photodetectors (32,31) are disposed on said main surface of said substrate (20) adjacent to the light input side and the light output side of said lightguide layer (5) respectively.

3. A semiconductor laser device as claimed in claim 2 wherein said lightguide layer (5) is of LiNb0₃ containing diffused Ti.

4. A semiconductor laser device as claimed in claim 1 wherein:
said substrate (20,21) is an Si substrate (21); an insulating layer (7) is provided at a region of said main surface of said Si substrate (21) where the semiconductor laser array (1) is fixed ;
said plurality of photodetectors (32,31) is provided integrated with said Si substrate (21) and said lightguide layer (5) overlaps said plurality of integrated photodetectors (31,32).

5. A semiconductor laser device as claimed in claim 4 wherein said photodetectors (32,31) comprise diffused impurities into said Si substrate (21).

6. A semiconductor laser device as claimed in claim 5 wherein said lightguide layer (5) includes a surface grating (8) at the region of overlap of said lightguide layer (5) and said plurality of photodetectors (32,31) to diffract said focused second laser light bundles (A",B") towards said respective photodetectors (32,31) thereby to enhance optical coupling between said lightguide layer (5) and said plurality of photodetectors (32,31).

7. A semiconductor laser device as claimed in any preceding claim wherein said semiconductor laser array (1) is of monolithic structure.

## Patentansprüche

1. Halbleiterlaservorrichtung mit:
einem Substrat (20, 21);
einer vordere und hintere Laserflächen aufweisenden, auf einer Hauptoberfläche des Substrats (20, 21) aufgebrachten Halbleiterlaseranordnung (1), die im Betrieb jeweils eine Mehrzahl von ersten Laserlichtbündeln (A, B) von der vorderen Laserfläche emittiert und die im Betrieb eine gleiche Mehrzahl von zweiten Laserlichtbündeln (A', B'), die Lichtintensitäten proportional zu den Lichtintensitäten der ersten Laserlichtbündel (A, B) aufweisen, von der hinteren Laserfläche emittiert;
einer gleichen Mehrzahl von Photodetektoren (32, 31), die zum Aufnehmen und Erfassen der entsprechenden zweiten Laserlichtbündel (A', B') angeordnet sind, um eine unabhängige Überwachung der Lichtbündelintensitäten der entsprechenden ersten Laserlichtbündel (A, B) bereitzustellen; und
einer Lichtführungseinrichtung (5, 6), die ebenso auf der Hauptoberfläche des Substrats (20, 21) angeordnet und zwischen der Halbleiterlaseranordnung (1) und der Mehrzahl von Photodetektoren (31, 31) aufgebracht ist, zum Führen des jeweils entsprechenden zweiten Laserlichtbündels (A', B') zu dem jeweils entsprechenden Photodetektor (31, 31);
wobei die Halbleiterlaservorrichtung dadurch gekennzeichnet ist, daß:
die Lichtführungseinrichtung (5, 6) eine Lichtführungsschicht (5) aufweist, die auf einer Hauptoberfläche des Substrats (20, 21) aufgebracht ist, wobei in der Schicht (5) eine Linse (6) definiert ist, die zum Abfangen und Fokussieren aller zweiten Laserlichtbündel (A', B') auf einen getrennten Brennpunkt in der Ebene der Lichtführungsschicht (5) angeordnet ist; und
die Mehrzahl der Photodetektoren (32, 31) ist auf der Hauptoberfläche des Substrats (20, 21) in einer planaren Anordnung relativ sowohl zu der Halbleiterlaseranordnung (1) als auch zu der Lichtführungsschicht (5) nahe der Austrittsstellen der zweiten Laserlichtbündel (A', B') an den Positionen aufgebracht, wo die geführten Laserlichtbündel (A", B") an der Austrittsseite der Lichtführungsschicht (5) fokussiert werden, und ist mit der Lichtführungsschicht (5) zum Aufnehmen und Erfassen der Mehrzahl von zweiten Laserlichtbündeln (A", B"), die durch die Linsen (6) fokussiert sind, gekoppelt.

2. Halbleiterlaservorrichtung nach Anspruch 1, bei der
das Substrat (20, 21) ein isolierendes Substrat (20) ist; und
die Halbleiterlaseranordnung (1) und die Mehrzahl von Photodetektoren (32, 31) auf einer Hauptoberfläche (20) jeweils nahe der Lichteintrittsseite bzw. der Lichtaustrittsseite der Lichtführungsschicht (5) aufgebracht sind.

3. Halbleiterlaservorrichtung nach Anspruch 2, bei der die Lichtführungsschicht (5) aus LiNbO3, das diffundiertes Ti enthält, besteht.

4. Halbleiterlaservorrichtung nach Anspruch 1, bei der
das Substrat (20, 21) ein Si-Substrat (21) ist;
eine isolierende Schicht (7) an einem Bereich der Hauptoberfläche des Si-Substrats (21), wo die Halbleiterlaseranordnung (1) fixiert ist, vorgesehen ist;
die Mehrzahl der Photodetektoren (32, 31) mit dem Si-Substrat (21) integriert vorgesehen ist; und
die Lichtführungsschicht (5) die Mehrzahl der integrierten Photodetektoren (31, 32) überlappt.

5. Halbleiterlaservorrichtung nach Anspruch 4, bei der die Photodetektoren (32, 31) in das Si-Substrat (21) diffundierte Störstellen aufweisen.

6. Halbleiterlaservorrichtung nach Anspruch 5, bei der die Lichtführungsschicht (5) bei dem Überlappungsbereich der Lichtführungsschicht (5) und der Mehrzahl der Photodetektoren (32, 31) eine Gitteroberfläche (8) beinhaltet, um die fokussierten zweiten Laserlichtbündel (A'', B'') in Richtung der entsprechenden Photodetektoren (32, 31) zu beugen, um dadurch die optische Kopplung zwischen der Lichtführungsschicht (5) und der Mehrzahl der Photodetektoren (32, 31) zu verbessern.

7. Halbleiterlaservorrichtung nach einem der vorhergehenden Ansprüche, bei der die Halbleiterlaseranordnung einen monolitischen Aufbau aufweist.

## Revendications

1. Dispositif laser à semi-conducteur comprenant :
un substrat (20, 21);
un groupement de lasers à semi-conducteur (1), disposé à une surface principale dudit substrat (20, 21), ayant des facettes avant et arrière, émettant en utilisation un cetain nombre de premiers faisceaux de lumière laser (A,B) de la facette avant et émettant en utilisation de la facette arrière, une même pluralité de seconds faisceaux de lumière laser (A', B') à intensités lumineuses proportionnelles aux intensités lumineuses desdits premiers faisceaux de lumière laser (A,B), respectivement;
une même pluralité de photo-détecteurs (32, 31) agencés pour recevoir et détecter les seconds faisceaux de lumière laser respectifs (A', B') pour réaliser un contrôle indépendant des intensités de faisceaux de lumière des premiers faisceaux de lumière laser respectifs (A,B); et
un moyen de guidage de lumière (5, 6), également disposé à ladite surface principale dudit substrat (20, 21), agencé entre ledit groupement de lasers à semi-conducteur (1) et ladite pluralité de photo-détecteurs (32, 31), pour guider chaque second faisceau de lumière laser respectif (A', B') à chaque photo-détecteur (32, 31);
lequel dispositif laser à semi-conducteur est caractérisé en ce que :
ledit moyen de guidage de lumière (5,6) comprend une couche de guidage de lumière (5), disposée sur ladite surface principale dudit substrat (20,21), laquelle couche (5) a définie dans celle-ci une lentille (6) agencée pour intercepter et focaliser chacun desdits seconds faisceaux de lumière laser (A', B') à une focalisation séparée dans le plan de ladite couche de guidage de lumière (5); et
ladite pluralité de photo-détecteurs (32,31) est disposée à ladite surface principale dudit substrat (20, 21) en une configuration plane par rapport à la fois au groupement de lasers à semi-conducteur (1) et à la couche de guidage de lumière (5), adjacente aux points de sortie desdits seconds faisceaux de lumière laser (A', B'), à des positions où les faisceaux de lumière laser guidés (A", B") sont focalisés au côté de sortie de la couche de guidage de lumière (5) et est couplée à ladite couche de guidage de lumière (5) pour recevoir et détecter ladite pluralité de seconds faisceaux de lumière laser (A", B") focalisés par ladite lentille (6).

2. Dispositif laser à semi-conducteur comme revendiqué en revendication 1 dans lequel :
le substrat précité (20,21) est un substrat isolant (20); et
le groupement de lasers à semi-conducteur précité (1) et la pluralité précitée de photo-détecteurs (32, 31) sont disposés sur la surface principale précitée dudit substrat (20) adjacente au côté d'entrée de lumière et au côté de sortie de lumière de la couche de guidage de lumière précitée (5), respectivement.

3. Dispositif laser à semi-conducteur comme revendiqué en revendication 2 dans lequel la couche de guidage de lumière précitée (5) est en LiNbO₃ contenant du Ti diffusé.

4. Dispositif laser à semi-conducteur comme revendiqué en revendication 1 dans lequel :
le substrat précité (20, 21) est un substrat en Si (21); une couche isolante (7) est prévue à une région de la surface principale précitée du substrat précité en Si (21) où le groupement de lasers à semi-conducteur (1) est fixé;
la pluralité précitée de photo-détecteurs (31, 31) est réalisée intégrée audit substrat en Si (21) et ladite couche de guidage de lumière (5) chevauche ladite pluralité de photo-détecteurs intégrés (31, 32).

5. Dispositif laser à semi-conducteur comme revendiqué en revendication 4 dans lequel les photo-détecteurs précités (32, 31) comprennent des impuretés diffusées dans le substrat précité en Si (21).

6. Dispositif laser à semi-conducteur comme revendiqué en revendication 5 dans lequel la couche de guidage de lumière précitée (5) comprend un sélecteur de mode de surface (8) à la région de chevauchement de la couche de guidage de lumière précitée (5) et de la pluralité précitée de photo-détecteurs (32, 31) pour diffracter les seconds faisceaux de lumière laser focalisés précités (A", B") vers lesdits photo-détecteurs respectifs (32, 31) pour améliorer de la sorte un couplage optique entre la couche de guidage de lumière (5) et la pluralité de photo-détecteurs (32, 31).

7. Dispositif laser à semi-conducteur comme revendiqué dans une quelconque des revendications précédentes dans lequel le groupement de lasers à semi-conducteur précité (1) est d'une structure monolitique.
